# EUROPEAN PATENT APPLICATION

(11) **EP 3 764 490 A1**
(43) Date of publication of application: **13.01.2021**
(21) Application number: 19763697.0
(22) Date of filing: 07.02.2019
(51) Int. Cl.: H01S 5/183

(54) **SURFACE-EMITTING LASER**

(30) Priority: 07.03.2018 JP 2018041042
(71) Applicant: Sony Semiconductor Solutions Corporation, Atsugi-shi, Kanagawa 243-0014 (JP)
(72) Inventor: ARAKIDA, Takahiro, Kikuchi-gun, Kumamoto 869-1102 (JP); KIMURA, Takayuki, Kikuchi-gun, Kumamoto 869-1102 (JP); YOSHIDA, Yuuta, Kikuchi-gun, Kumamoto 869-1102 (JP)
(74) Representative: D Young & Co LLP
(86) International application number: PCT/JP2019/004373
(87) International publication number: WO 2019/171869

(57) **Abstract**

A surface emitting laser according to an embodiment of the present disclosure includes an active layer, a first DBR layer and a second DBR layer sandwiching the active layer, and a dielectric layer and a reflection metal layer corresponding to a terminal end of a reflecting mirror on a side of the second DBR layer when viewed from the active layer.

## Description

### Technical Field

The present disclosure relates to a surface emitting laser.

### Background Art

In a surface emitting laser, a DBR (Diffractive Bragg Reflector) is used.

### Citation List

### Patent Literature

PTL 1: Japanese Unexamined Patent Application Publication No. 2005-085836

### Summary of the Invention

Incidentally, in the field of surface emitting lasers, enhancement of device properties and productivity improvement by a reduction in the number of pairs in DBRs are expected. It is therefore desirable to provide a surface emitting laser that makes it possible to reduce the number of pairs in DBRs.

A surface emitting laser according to an embodiment of the present disclosure includes an active layer, a first DBR layer and a second DBR layer sandwiching the active layer, and a dielectric layer and a reflection metal layer corresponding to a terminal end of a reflecting mirror on a side of the second DBR layer when viewed from the active layer.

In the surface emitting laser according to the embodiment of the present disclosure, the dielectric layer and the reflection metal layer are provided at the terminal end of the reflecting mirror on the side of the second DBR layer when viewed from the active layer. Laser oscillation is thus caused to occur at a predetermined oscillation wavelength by the first DBR layer and the second DBR layer, and the dielectric layer and a reflection electrode layer. At this time, even in a case where the number of pairs in the second DBR layer is less than the number of pairs in the first DBR layer, it is possible to cause the laser oscillation at the predetermined oscillation wavelength, and besides, it is possible to maintain light extraction efficiency at a high level, while suppressing a rise in threshold gain of the laser oscillation.

### Brief Description of Drawings

[FIG. 1] FIG. 1 illustrates a cross-sectional configuration example of a surface emitting laser according to a first embodiment of the present disclosure.
[FIG. 2] FIG. 2 illustrates a top surface configuration example of the surface emitting laser in FIG. 1.
[FIG. 3] FIG. 3 illustrates a back surface configuration example of the surface emitting laser in FIG. 1.
[FIG. 4A] FIG. 4A illustrates an example of a manufacturing process of a light emitting element in FIG. 1.
[FIG. 4B] FIG. 4B illustrates an example of a manufacturing process following the manufacturing process in FIG. 4A.
[FIG. 4C] FIG. 4C illustrates an example of a manufacturing process following the manufacturing process in FIG. 4B.
[FIG. 4D] FIG. 4D illustrates an example of a manufacturing process following the manufacturing process in FIG. 4C.
[FIG. 4E] FIG. 4E illustrates an example of a manufacturing process following the manufacturing process in FIG. 4D.
[FIG. 5] Part (A) of FIG. 5 illustrates a cross-sectional configuration example of a semiconductor layer in which an n-DBR layer is formed on a GaAs substrate, and part (B) of FIG. 5 illustrates a cross-sectional configuration example of a semiconductor layer in which an Al mirror layer, a λ/4 SiO₂ layer, and an n-DBR layer are formed on a GaAs substrate.
[FIG. 6] FIG. 6 illustrates a relationship between the number of pairs in an n-DBR and a reflectance of the n-DBR in each of parts (A) and (B) of FIG. 5 when laser light of a wavelength of 940 nm enters the n-DBR in each of parts (A) and (B) of FIG. 5.
[FIG. 7] Part (A) of FIG. 7 illustrates a cross-sectional configuration example of a laser structure in which a cavity layer, a current confinement layer, and a p-DBR layer are stacked on the semiconductor layer in part (A) of FIG. 5, and part (B) of FIG. 7 illustrates a cross-sectional configuration example of a laser structure in which a cavity layer, a current confinement layer, and a p-DBR layer are stacked on the semiconductor layer in part (B) of FIG. 5.
[FIG. 8] FIG. 8 illustrates a relationship between the number of pairs in the n-DBR and a threshold gain of oscillation in the laser structure in each of parts (A) and (B) of FIG. 7.
[FIG. 9] FIG. 9 illustrates a relationship between the number of pairs in the n-DBR and light extraction efficiency in the laser structure in each of parts (A) and (B) of FIG. 7.
[FIG. 10] FIG. 10 illustrates a modification example of a cross-sectional configuration of the surface emitting laser in FIG. 1.
[FIG. 11] FIG. 11 illustrates a top surface configuration example of the surface emitting laser in FIG. 10.
[FIG. 12] FIG. 12 illustrates a cross-sectional configuration example of a surface emitting laser according to a second embodiment of the present disclosure.
[FIG. 13] FIG. 13 illustrates a top surface configuration example of the surface emitting laser in FIG. 12.
[FIG. 14] FIG. 14 illustrates a back surface configuration example of the surface emitting laser in FIG. 12.
[FIG. 15A] FIG. 15A illustrates an example of a manufacturing process of a light emitting element in FIG. 12.
[FIG. 15B] FIG. 15B illustrates an example of a manufacturing process following the manufacturing process in FIG. 15A.
[FIG. 15C] FIG. 15C illustrates an example of a manufacturing process following the manufacturing process in FIG. 15B.
[FIG. 15D] FIG. 15D illustrates an example of a manufacturing process following the manufacturing process in FIG. 15C.
[FIG. 15E] FIG. 15E illustrates an example of a manufacturing process following the manufacturing process in FIG. 15D.

### Modes for Carrying Out the Invention

Embodiments of the present disclosure will be described below in detail with reference to the drawings. The following description describes a specific example of the present disclosure, and the present disclosure is not limited to the following implementations. Further, as for positions, dimensions, dimension ratios, etc. of components illustrated in each of the drawings, the present disclosure is not limited thereto, either. It is to be noted that the description is given in the following order.

### 1. First Embodiment

An example in which a dielectric layer and a reflection metal layer are provided in a surface emitting laser of back surface output type

### 2. Modification Example of First Embodiment

An example in which the dielectric layer is replaced with a transparent conductor layer

### 3. Second Embodiment

An example in which a dielectric layer and a reflection metal layer are provided in a surface emitting laser of top surface output type

### <1. First Embodiment

### [Configuration]

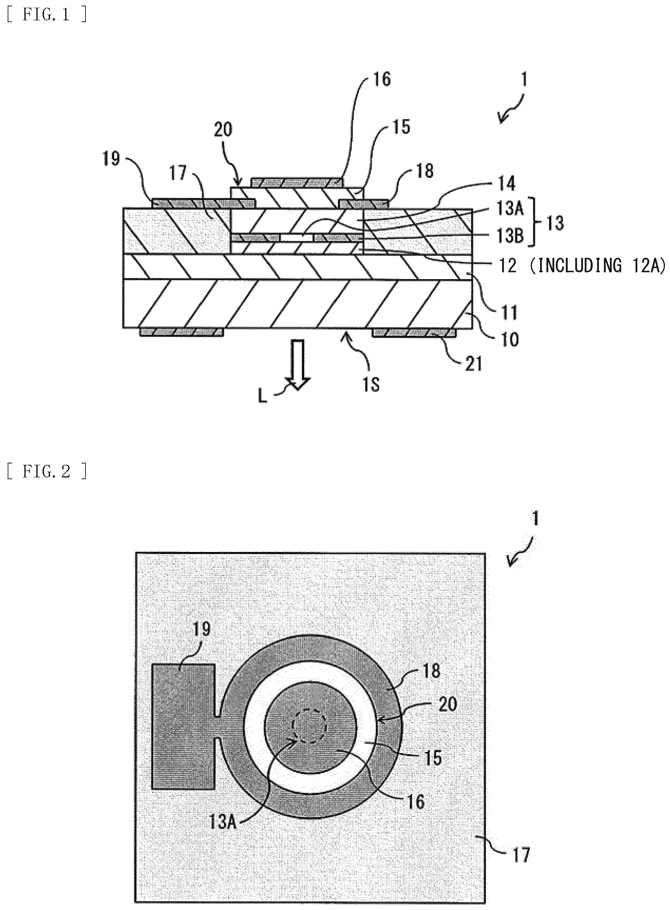

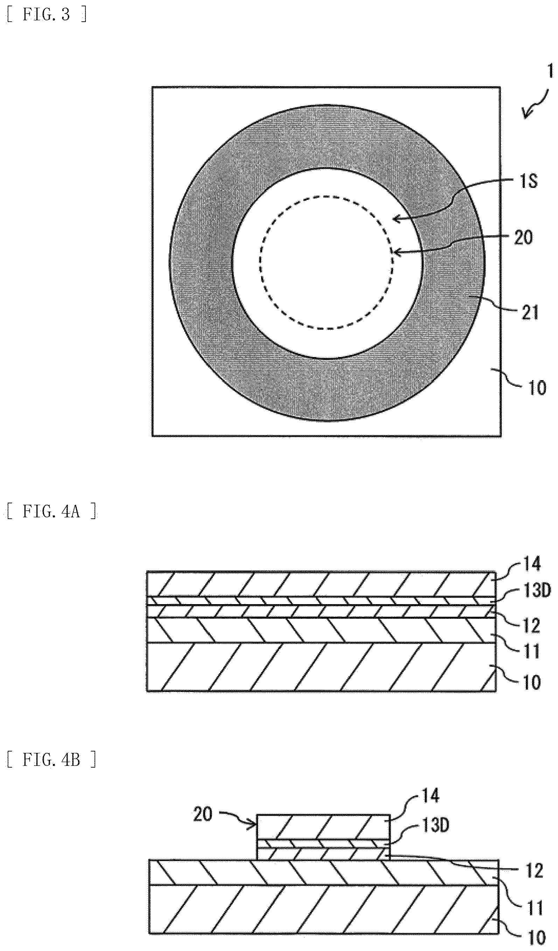

A surface emitting laser 1 according to a first embodiment of the present disclosure will be described. FIG. 1 illustrates a cross-sectional configuration example of the surface emitting laser 1. FIG. 2 illustrates a top surface configuration example of the surface emitting laser 1. FIG. 3 illustrates a back surface configuration example of the surface emitting laser 1.

The surface emitting laser 1 is a laser of a back surface output type suitably applicable to a use in which a low profile and low power consumption are desired, a use in which a low profile and a large area are desired, etc. The surface emitting laser 1 includes, for example, a cavity layer 12 including an active layer 12A. The cavity layer 12 is designed to suit an oscillation wavelength λ₀ and a use.

The surface emitting laser 1 further includes, for example, a vertical cavity. The vertical cavity oscillates at the oscillation wavelength λ₀ owing to two DBRs (distributed Bragg reflectors) opposed to each other in a normal direction of a substrate 10. The vertical cavity includes, for example, two DBR layers sandwiching the cavity layer 12 and a current confinement layer 13. It is to be noted that the vertical cavity may include, for example, two DBR layers sandwiching the substrate 10, the cavity layer 12, and the current confinement layer 13. The above-described two DBR layers include, for example, a DBR layer 11 (a first DBR layer) described later, and a DBR layer 14 (a second DBR layer) described later. The DBR layer 11 is, for example, formed in contact with a top surface of the substrate 10. The DBR layer 14 is, for example, disposed at a position relatively away from the substrate 10 (i.e., a position away from a light output surface 1S) in comparison with the DBR layer 11. The vertical cavity further includes, for example, a dielectric layer 15 and a reflection metal layer 16. The dielectric layer 15 and the reflection metal layer 16 are layers that assist a function of the DBR layer 14 and that contribute to a reduction in the number of pairs in the DBR layer 14. In other words, the dielectric layer 15 and the reflection metal layer 16 correspond to a terminal end of a reflecting mirror on a side of the DBR layer 14 when viewed from the cavity layer 12.

The surface emitting laser 1 includes, for example, the DBR layer 11, the cavity layer 12, the current confinement layer 13, the DBR layer 14, the dielectric layer 15, and the reflection metal layer 16 that are provided on the substrate 10 in this order from the substrate 10. The surface emitting laser 1 further includes, for example, an embedding layer 17, an electrode layer 18, and a pad electrode 19 on a top surface side of the substrate 10. The surface emitting laser 1 further includes, for example, an electrode layer 21 on a back surface side of the substrate 10. The surface emitting laser 1 may include, for example, a contact layer intended to bring the substrate 10 and the DBR layer 11 into ohmic contact with each other. The surface emitting laser 1 may further include, for example, a contact layer intended to bring the DBR layer 14 and the electrode layer 18 into ohmic contact with each other.

In the surface emitting laser 1, for example, at least the cavity layer 12, the current confinement layer 13, and the DBR layer 14, of the semiconductor layer including the DBR layer 11, the cavity layer 12, the current confinement layer 13, and the DBR layer 14, serve as a mesa section 20 shaped like a column. A cross-section of the mesa section 20 in a stacking direction is, for example, circular. In a side face of the mesa section 20, at least a side face of each of the cavity layer 12, the current confinement layer 13, and the DBR layer 14 is exposed.

The substrate 10 is a crystal growth substrate used when the DBR layer 11, the cavity layer 12, the current confinement layer 13, and the DBR layer 14 undergo epitaxial crystal growth. The substrate 10, the DBR layer 11, the cavity layer 12, the current confinement layer 13, and the DBR layer 14 each include, for example, a GaAs-based semiconductor.

The substrate 10 is a substrate having a light transmitting property to light to be emitted from the cavity layer 12, and is, for example, an n-type GaAs substrate. For example, silicon (Si) or the like is included as an n-type impurity in the n-type GaAs substrate. The DBR layer 11 includes, for example, a low refractive index layer and a high refractive index layer that are alternately stacked. The low refractive index layer includes, for example, n-type Alₓ₁Ga₁₋ₓ₁As (0 < x1 < 1) having a thickness of λ₀(4n), where λ₀ is an oscillation wavelength, and n is a refractive index of the low refractive index layer. The oscillation wavelength λ₀ is, for example, 940 nm that is a wavelength for optical communication. The high refractive index layer includes, for example, n-type Alₓ₂Ga₁₋ₓ₂As (0 ≤ x2 < x1) having a thickness of λ₀/(4n), where n is a refractive index of the high refractive index layer. The low refractive index layer includes a material having a higher Al (aluminum) composition ratio than that of the high refractive index layer. For example, silicon (Si) or the like is included as an n-type impurity in the DBR layer 11.

The cavity layer 12 is designed to suit the oscillation wavelength λ₀ and a use. The cavity layer 12 includes, for example, a stack in which the active layer 12A and a barrier layer are alternately stacked. The cavity layer 12 may further include, for example, a pair of guide layers sandwiching the above-described stack. In a case where a laser characteristic of the oscillation wavelength λ₀ of 940 nm is to be obtained, the above-described stack has, for example, a configuration in which the active layer 12A including In_{0.2}Ga_{0.8}As having a thickness of 8 nm and a barrier layer including GaAs having a thickness of 10 nm are alternately stacked, and the above-described guide layers each include, for example, Al_{0.4}Ga_{0.6}As having a thickness of 100 nm. The cavity layer 12 includes, for example, a non-doped semiconductor. Of the cavity layer 12, a region facing a current injection region 13A described later serves as a light emission region when a current is injected into the surface emitting laser 1.

The current confinement layer 13 includes an opening (the current injection region 13A) for confinement of a current to be injected into the cavity layer 12. The current injection region 13Ais, for example, circular. The current confinement layer 13 includes a current confinement region 13B around the current injection region 13A. The current confinement region 13B includes an insulating material, for example, Al₂Oₓ. The current confinement layer 13 is formed by, for example, partially oxidizing AlGaAs having a high Al composition, or AlAs. The current confinement layer 13 may be provided, for example, at a position of the low refractive index layer close to the cavity layer 12 within the DBR layer 14.

The DBR layer 14 includes, for example, a low refractive index layer and a high refractive index layer that are alternately stacked. The low refractive index layer includes, for example, p-type Alₓ₃Ga₁₋ₓ₃As (0 < x3 < 1) having a thickness of λ₀/(4n), where n is a refractive index of the low refractive index layer. The high refractive index layer includes, for example, p-type Alₓ₄Ga₁₋ₓ₄As (0 ≤ x4x < x3) having a thickness of λ₀/(4n), where n is a refractive index of the high refractive index layer. The low refractive index layer includes a material having a higher Al (aluminum) composition ratio than that of the high refractive index layer. For example, carbon (C), zinc (Zn), magnesium (Mg), beryllium (Be), etc. are included as p-type impurities in the DBR layer 14.

The number of pairs of the low refractive index layer and the high refractive index layer in the DBR layer 14 is, for example, less than the number of pairs of the low refractive index layer and the high refractive index layer in the DBR layer 11. The number of pairs in the DBR layer 14 is half or less the number of pairs necessary to serve as a DBR layer when the dielectric layer 15 and the reflection metal layer 16 are not provided. One reason for this is that the dielectric layer 15 and the reflection metal layer 16 assist a light reflection function of the DBR layer 14, and it is thus possible to reduce the number of pairs of the low refractive index layer and the high refractive index layer in the DBR layer 14 by ability of the dielectric layer 15 and the reflection metal layer 16 to reflect light.

The dielectric layer 15 is, for example, in contact with the DBR layer 14 at a side opposite to the cavity layer 12. The dielectric layer 15 includes, for example, Al₂O₃, SiO₂, SiNx, TiO₂, or Ta₂O₅ having a thickness of λ₀/(4n), where n is a refractive index of the dielectric layer 15. The reflection metal layer 16 is, for example, in contact with the DBR layer 14 with the dielectric layer 15 interposed therebetween. The reflection metal layer 16 includes, for example, gold (Au), silver (Ag), or aluminum (Al). The reflection metal layer 16 has a film thickness of, for example, 20 nm or more.

The electrode layer 18 is formed between the DBR layer 14 and the dielectric layer 15. The electrode layer 18 includes an opening at least at a portion opposed to the current injection region 13A, and is formed in contact with an outer edge of a top surface of the DBR layer 14. In other words, the electrode layer 18 for injection of a current into the cavity layer 12 of the surface emitting laser 1 is provided on a path different from an optical path in a vertical cavity structure. The electrode layer 18 has, for example, a structure in which titanium (Ti), platinum (Pt), and gold (Au) are stacked in order from the top surface of the DBR layer 14, and is electrically coupled to the DBR layer 14.

The pad electrode 19 serves as an external terminal of the surface emitting laser 1. The pad electrode 19 is electrically coupled to the electrode layer 18. The pad electrode 19 includes, for example, titanium (Ti), platinum (Pt), and gold (Au) stacked in this order. The pad electrode 19 is, for example, formed integrally with the electrode layer 18. The pad electrode 19 is, for example, formed in contact with a top surface of the embedding layer 17.

The embedding layer 17 is a layer intended to provide a formation surface for the pad electrode 19. The embedding layer 17 is formed around the mesa section 20, and embeds a portion of the mesa section 20. It is preferable that the top surface of the embedding layer 17 and the top surface of the DBR layer 14 be nearly equal to each other in height. The embedding layer 17 includes a resin having an insulation property, for example, polyimide.

The electrode layer 21 serves as an external terminal of the surface emitting laser 1. The electrode layer 21 is electrically coupled to the substrate 10. The electrode layer 21 includes, for example, an alloy of gold (Au) and germanium (Ge), nickel (Ni), and gold (Au) stacked in this order from the substrate 10. The electrode layer 21 includes an opening at least at a portion opposed to the current injection region 13A, and is formed in contact with an outer edge of the back surface of the substrate 10. Of the back surface of the substrate 10, a surface exposed inside the opening of the electrode layer 21 is the light output surface 1S from which light (laser light L) from the surface emitting laser 1 is to be outputted to outside.

### [Method of Manufacturing]

Next, a method of manufacturing the surface emitting laser 1 according to the present embodiment will be described. FIG. 4A to FIG. 4E illustrate an example of a procedure of manufacturing the surface emitting laser 1.

To manufacture the surface emitting laser 1, on the substrate 10 including, for example, GaAs, a compound semiconductor is collectively formed by, for example, an epitaxial crystal growth method such as an MOCVD (Metal Organic Chemical Vapor Deposition) method. At this time, for example, a methyl-based organic metal gas such as trimethylaluminum (TMAl, trimethylgallium (TMGa), or trimethylindium (TMIn), and an arsine (AsH₃) gas are used as raw materials of the compound semiconductor, disilane (Si₂H₆), for example, is used as a raw material of a donor impurity, and carbon tetrabromide (CBr₄), for example, is used as a raw material of an acceptor impurity.

First, on a surface of the substrate 10, the DBR layer 11, the cavity layer 12, an oxidation layer 13D, and the DBR layer 14 are formed in this order by, for example, an epitaxial crystal growth method such as the MOCVD method (FIG. 4A). Next, for example, a circular resist layer (not illustrated) is formed, and then among the DBR layer 14, the oxidization layer 13D, the cavity layer 12, and the DBR layer 11, at least the DBR layer 14, the oxidation layer 13D, and the cavity layer 12 are selectively etched using this resist layer as a mask. At this time, it is preferable to use, for example, RIE (Reactive Ion Etching) with a Cl-based gas. For example, as illustrated in FIG. 4B, the mesa section 20 shaped like a column is thereby formed to have a height reaching at least the DBR layer 14, the oxidation layer 13D, and the cavity layer 12, among the DBR layer 14, the oxidation layer 13D, the cavity layer 12, and the DBR layer 11. At this time, the oxidation layer 13D is exposed in the side face of the mesa section 20. Thereafter, the resist layer is removed.

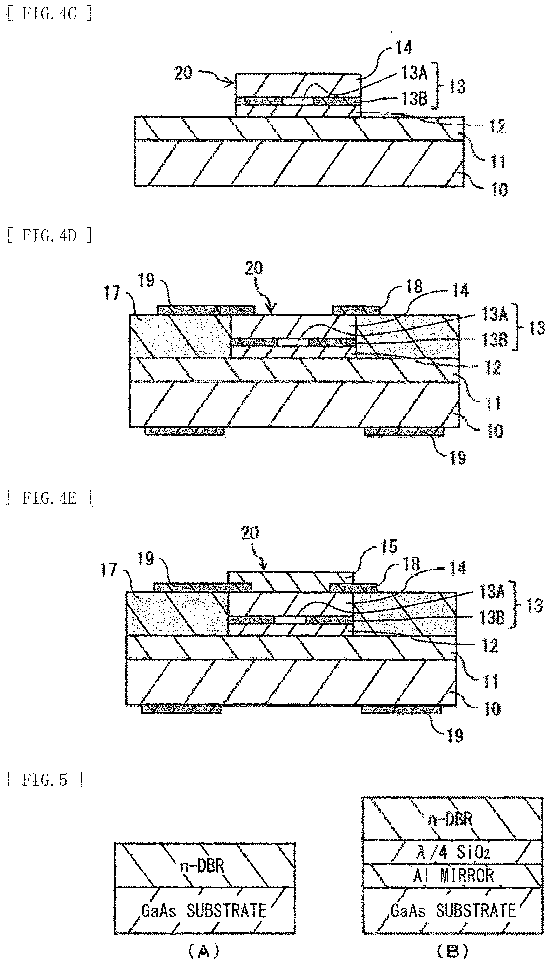

Next, in a water-vapor atmosphere, oxidation treatment is performed at a high temperature to selectively oxidize Al included in the oxidation layer 13D from the side face of the mesa section 20. Alternatively, Al included in the oxidation layer 13D is selectively oxidized from the side face of the mesa section 20 by a wet oxidation method. This makes an outer edge region of the oxidation layer 13D into an insulating layer (aluminum oxide) in the mesa section 20, thereby forming the current confinement layer 13 (FIG. 4C). Subsequently, the embedding layer 17 including, for example, an insulating resin such as polyimide is formed around the mesa section 20, and then the electrode layer 18 and the pad electrode 19 are formed on the top surface of each of the DBR layer 14 and the embedding layer 17 (FIG. 4D). Further, the electrode layer 21 is formed on the back surface of the substrate 10. Then, for example, a dielectric layer is formed by sputtering, and an unnecessary portion of the dielectric layer thus formed is removed by a lift-off method. In this way, the dielectric layer 15 is formed on a top surface of the mesa section 20 (FIG. 4E). Finally, a reflection metal layer is formed by a vapor deposition method, and an unnecessary portion of the reflection metal layer thus formed is removed by a lift-off method. The reflection metal layer 16 is thereby formed (FIG. 1). In this way, the surface emitting laser 1 is manufactured.

### [Operation]

In the surface emitting laser 1 having such a configuration, when a predetermined voltage is applied between the pad electrode 19 electrically coupled to the DBR layer 14 and the electrode layer 21 electrically coupled to the DBR layer 11, a current is injected into the cavity layer 12 through the current injection region 13A, thus causing light emission to occur as a result of recombination of electrons and holes. This results in laser oscillation at the oscillation wavelength λ₀ caused by the cavity layer 12, the pair of DBR layers 11 and 14, the dielectric layer 15, and the reflection metal layer 16. Subsequently, light leaking out of the DBR layer 11 becomes beam-shaped laser light and is outputted from the light output surface 1S to outside.

### [Effects]

Next, effects of the surface emitting laser 1 according to the present embodiment will be described with reference to a comparative example.

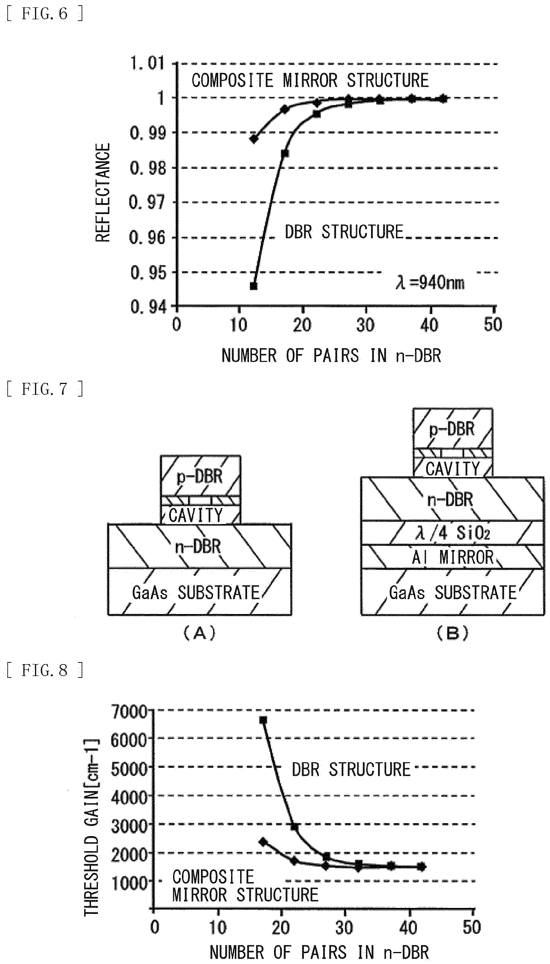

Part (A) of FIG. 5 illustrates a cross-sectional configuration example of a semiconductor layer in which an n-DBR layer is formed on a GaAs substrate. Part (B) of FIG. 5 illustrates a cross-sectional configuration example of a semiconductor layer in which an Al mirror layer, a λ/4 SiO₂ layer, and an n-DBR layer are formed on a GaAs substrate. FIG. 6 illustrates a relationship between the number of pairs in an n-DBR and a reflectance of the n-DBR in each of parts (A) and (B) of FIG. 5 when laser light of a wavelength of 940 nm enters the n-DBR in each of parts (A) and (B) of FIG. 5. A graph on a side of a "DBR structure" in FIG. 6 represents the reflectance of the n-DBR in part (A) of FIG. 5, and a graph on a side of a "composite mirror structure" in FIG. 6 represents the reflectance of the n-DBR in part (B) of FIG. 5. It is to be noted that, in part (B) of FIG. 5, the Al mirror layer is an example of the "reflection metal layer 16" of the present embodiment, the λ/4 SiO₂ layer is an example of the "dielectric layer 15" of the present embodiment, and the n-DBR is an example of the "DBR layer 11" of the present embodiment.

It is apparent from FIG. 6 that the "compound mirror structure" exhibits a smaller amount of fall of the reflectance than the "DBR structure" even if the number of pairs in the n-DBR decreases. Further, even in a case where the number of pairs in the n-DBR is in the neighborhood of 20, the reflectance of the "compound mirror structure" is not less than 0.995 (= 99.5%), thus falling within a range usable for practical applications.

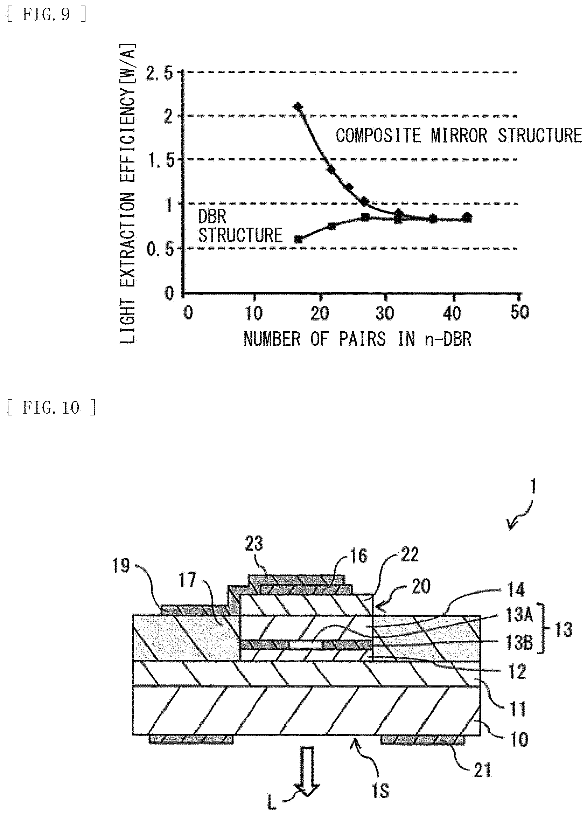

Part (A) of FIG. 7 illustrates a cross-sectional configuration example of a laser structure in which a cavity layer, a current confinement layer, and a p-DBR layer are stacked on the semiconductor layer in part (A) of FIG. 5. Part (B) of FIG. 7 illustrates a cross-sectional configuration example of a laser structure in which a cavity layer, a current confinement layer, and a p-DBR layer are stacked on the semiconductor layer in part (B) of FIG. 5. FIG. 8 illustrates a relationship between the number of pairs in the n-DBR and a threshold gain of oscillation in the laser structure in each of parts (A) and (B) of FIG. 7. FIG. 9 illustrates a relationship between the number of pairs in the n-DBR and light extraction efficiency in the laser structure in each of parts (A) and (B) of FIG. 7. A graph on the side of the "DBR structure" in FIG. 8 represents the threshold gain of the laser structure in part (A) of FIG. 7, and a graph on the side of the "composite mirror structure" in FIG. 8 represents the threshold gain of the laser structure in part (B) of FIG. 7. A graph on the side of the "DBR structure" in FIG. 9 represents the light extraction efficiency of the laser structure in part (A) of FIG. 7, and a graph on the side of the "composite mirror structure" in FIG. 9 represents the light extraction efficiency of the laser structure in part (B) of FIG. 7. It is to be noted that, in part (B) of FIG. 7, the cavity layer is an example of the "cavity layer 12" of the present embodiment, the current confinement layer is an example of the "current confinement layer 13" of the present embodiment, and the p-DBR is an example of the "DBR layer 14" of the present embodiment.

It is apparent from FIG. 8 that the "compound mirror structure" exhibits a smaller amount of rise of the threshold gain than the "DBR structure" even if the number of pairs in the n-DBR decreases. Further, even in a case where the number of pairs in the n-DBR is in the neighborhood of 20, the threshold gain of the "compound mirror structure" does not exceed 2500 cm-1, thus falling within a range usable for practical applications. Furthermore, it is apparent from FIG. 9 that the "compound mirror structure" exhibits a smaller decrease in the light extraction efficiency than the "DBR structure" even if the number of pairs in the n-DBR decreases.

In the present embodiment, the dielectric layer 15 and the reflection metal layer 16 assisting the function of the DBR layer 14 are provided at the terminal end of the reflecting mirror on the side of the DBR layer 14 when viewed from the cavity layer 12. Laser oscillation is thus caused to occur at the oscillation wavelength λ₀ by the cavity layer 12, the pair of DBR layers 11 and 14, the dielectric layer 15, and the reflection metal layer 16. At this time, even in a case where the number of pairs in the DBR layer 14 is less than the number of pairs in the DBR layer 11, it is possible to cause the laser oscillation at the oscillation wavelength λ₀, and besides, it is possible to maintain the light extraction efficiency at a high level, while suppressing a rise in the threshold gain of the laser oscillation. It is therefore possible to make the number of pairs in the DBR layer 14 less than the number of pairs in the DBR layer 11. As a result, it is possible to achieve enhancement of device properties and productivity improvement by a reduction in the number of pairs in the DBR layer 14. Further, the reduction in the number of pairs in the DBR layer 14 makes it easy to detect an F-P Dip wavelength, thereby making it possible to improve characteristic evaluation accuracy of an epi-wafer.

Further, in the present embodiment, the electrode layer 18 for injection of a current into the cavity layer 12 of the surface emitting laser 1 is provided on the path different from the optical path in the vertical cavity structure. Specifically, the electrode layer 18 is provided at a position where the current is directly injectable into the DBR layer 14 without interposition of the dielectric layer 15 and the reflection metal layer 16. For example, as illustrated in FIG. 1, the electrode layer 18 is provided between the DBR layer 14 and the dielectric layer 15, and is in contact with the top surface of the DBR layer 14 except a portion thereof opposed to the current injection region 13A. This makes it possible to reduce a drive voltage of the surface emitting laser 1. Further, because the electrode layer 18 is provided on the path different from the optical path in the vertical cavity structure, it is not necessary to use an electrically conductive material in forming the dielectric layer 15. It is thus possible to select, for the dielectric layer 15, a material and a manufacturing method that make it easy to control a film thickness.

### <2. Modification Example>

Next, a modification example of the surface emitting laser 1 according to the foregoing embodiment will be described.

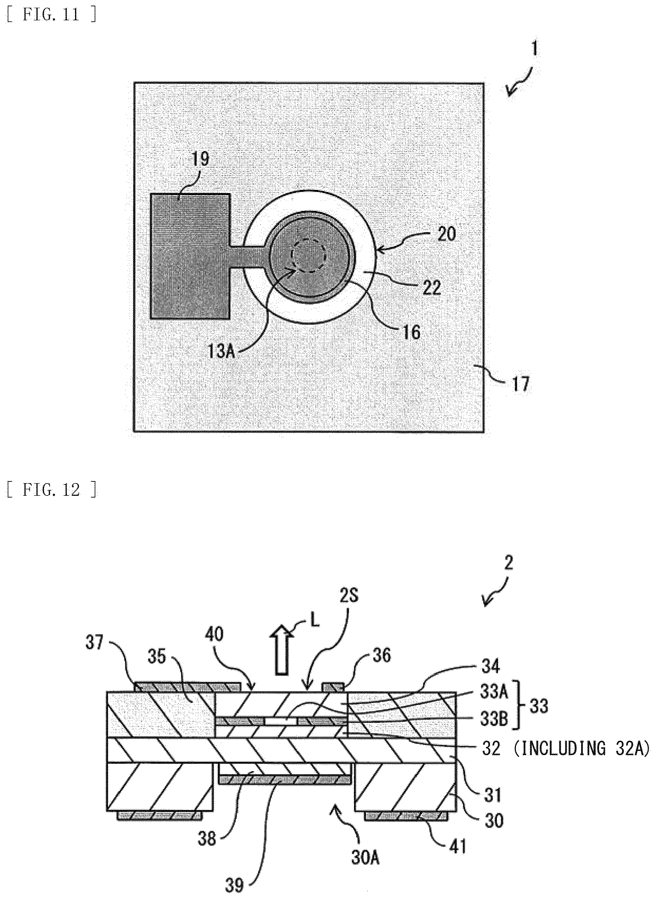

FIG. 10 illustrates a cross-sectional configuration example of the surface emitting laser 1 according to the present modification example. FIG. 11 illustrates a top surface configuration example of the surface emitting laser 1 in FIG. 10.

Further, in the present embodiment, a transparent conductor layer 22 is provided in place of the dielectric layer 15, and an electrode layer 23 is provided in place of the electrode layer 18. Here, the electrode layer 23 is electrically coupled to the transparent conductor layer 22 and the reflection metal layer 16, and is also electrically coupled to the pad electrode 19. In other words, the electrode layer 23 for injection of a current into the cavity layer 12 of the surface emitting laser 1 feeds the current to be injected into the cavity layer 12 to a path common to the optical path in the vertical cavity structure. The transparent conductor layer 22 includes, for example, a transparent conductor material such as ITO (Indium Tin Oxide) or ITiO (Indium Titanium Oxide) having a thickness of λ₀/(4n), where n is a refractive index of the transparent conductor layer 22. The transparent conductor layer 22 is electrically coupled to the DBR layer 14.

In the present modification example, the transparent conductor layer 22 and the reflection metal layer 16 assisting the function of the DBR layer 14 are provided at the terminal end of the reflecting mirror on side of the DBR layer 14 when viewed from the cavity layer 12. Laser oscillation is thus caused to occur at the oscillation wavelength λ₀ by the cavity layer 12, the pair of DBR layers 11 and 14, the transparent conductor layer 22, and the reflection metal layer 16. At this time, even in the case where the number of pairs in the DBR layer 14 is less than the number of pairs in the DBR layer 11, it is possible to cause the laser oscillation at the oscillation wavelength λ₀, and besides, it is possible to maintain the light extraction efficiency at a high level, while suppressing a rise in the threshold gain of the laser oscillation. It is therefore possible to make the number of pairs in the DBR layer 14 less than the number of pairs of the DBR layer 11. As a result, it is possible to achieve enhancement of device properties and productivity improvement by a reduction in the number of pairs in the DBR layer 14. Further, the reduction in the number of pairs in the DBR layer 14 makes it easy to detect an F-P Dip wavelength, thereby making it possible to improve characteristic evaluation accuracy of an epi-wafer.

Further, in the present modification example, the electrode layer 23 for injection of a current into the surface emitting laser 1 is provided on the transparent conductor layer 22. Specifically, the electrode layer 23 is provided at a position where the current is injectable into the DBR layer 14 with the transparent conductor layer 22 and the reflection metal layer 16 interposed therebetween. This makes it possible to manufacture the electrode layer 23 easily.

### <3. Second Embodiment

### [Configuration]

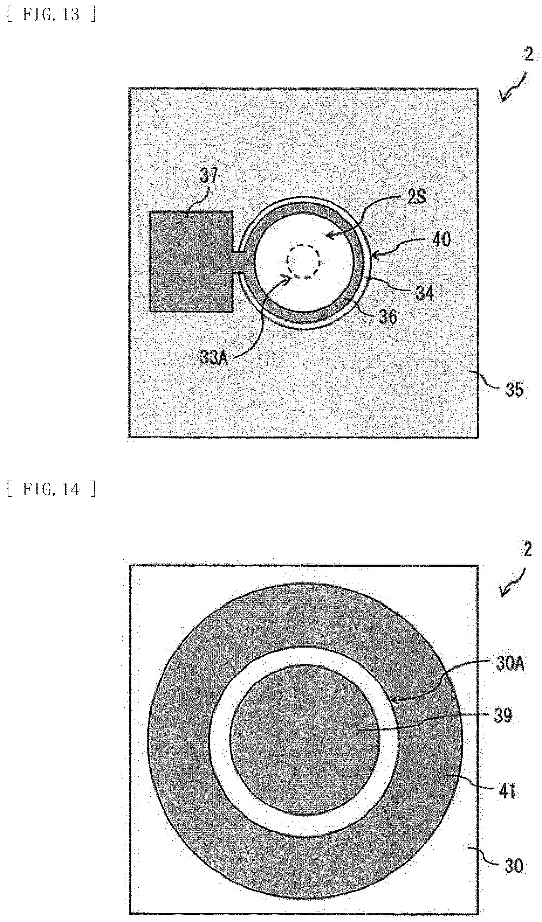

A surface emitting laser 2 according to a second embodiment of the present disclosure will be described. FIG. 12 illustrates a cross-sectional configuration example of the surface emitting laser 2. FIG. 13 illustrates a top surface configuration example of the surface emitting laser 2. FIG. 14 illustrates a back surface configuration example of the surface emitting laser 2.

The surface emitting laser 2 is a laser of a top surface output type suitably applicable to a use in which a low profile and low power consumption are desired, a use in which a low profile and a large area are desired, etc. The surface emitting laser 2 includes, for example, a cavity layer 32 including an active layer 32A. The cavity layer 32 is designed to suit an oscillation wavelength λ₀ and a use.

The surface emitting laser 2 further includes, for example, a vertical cavity. The vertical cavity oscillates at an oscillation wavelength λ₀ owing to two DBRs opposed to each other in a normal direction of a substrate 30. The vertical cavity includes, for example, two DBR layers sandwiching the cavity layer 32 and a current confinement layer 33. It is to be noted that the vertical cavity may include, for example, two DBR layers sandwiching the substrate 30, the cavity layer 32, and the current confinement layer 33. The above-described two DBR layers include, for example, a DBR layer 31 (the second DBR layer) described later, and a DBR layer 34 (the first DBR layer) described later. The DBR layer 31 is, for example, formed in contact with a top surface of the substrate 30. The DBR layer 34 is, for example, disposed at a position relatively away from the substrate 30 (i.e., a position close to a light output surface 2S) in comparison with the DBR layer 31. The vertical cavity further includes, for example, a dielectric layer 38 and a reflection metal layer 39. The dielectric layer 38 and the reflection metal layer 39 are layers that assist a function of the DBR layer 31 and that contribute to a reduction in the number of pairs in the DBR layer 31. In other words, the dielectric layer 38 and the reflection metal layer 39 correspond to a terminal end of a reflecting mirror on a side of the DBR layer 31 when viewed from the cavity layer 32.

The surface emitting laser 2 includes, for example, the DBR layer 31, the cavity layer 32, the current confinement layer 33, and the DBR layer 34 that are provided on the substrate 30 in this order from the substrate 30. The surface emitting laser 2 further includes, for example, an embedding layer 35, an electrode layer 36, and a pad electrode 37 on a top surface side of the substrate 30. The surface emitting laser 2 further includes, for example, an electrode layer 41 on a back surface side of the substrate 30. The surface emitting laser 2 includes, for example, inside an opening 30A of the substrate 30, the dielectric layer 38 in contact with the DBR layer 31 exposed inside the opening 30A of the substrate 30, and further includes the reflection metal layer 39 in contact with the dielectric layer 38. The opening 30A of the substrate 30 is formed at least in a region opposed to a current injection region 33A described later, for example, a region opposed to a mesa section 40 described later. In other words, the dielectric layer 38 and the reflection metal layer 39 are formed at least in a region opposed to the current injection region 33A, for example, a region opposed to the mesa section 40 described later. The surface emitting laser 2 may include, for example, a contact layer intended to bring the substrate 30 and the DBR layer 31 into ohmic contact with each other. The surface emitting laser 2 may further include, for example, a contact layer intended to bring the DBR layer 34 and the electrode layer 36 into ohmic contact with each other.

In the surface emitting laser 2, for example, at least the cavity layer 32, the current confinement layer 33, and the DBR layer 34, of a semiconductor layer including the DBR layer 31, the cavity layer 32, the current confinement layer 33, and the DBR layer 34, serve as the mesa section 40 shaped like a column. A cross-section of the mesa section 40 in the stacking direction is, for example, circular. In a side face of the mesa section 40, at least a side face of each of the cavity layer 32, the current confinement layer 33, and the DBR layer 34 is exposed.

The substrate 30 is a crystal growth substrate used when the DBR layer 31, the cavity layer 32, the current confinement layer 33, and the DBR layer 34 undergo epitaxial crystal growth. The substrate 30, the DBR layer 31, the cavity layer 32, the current confinement layer 33, and the DBR layer 34 each include, for example, a GaAs-based semiconductor.

The substrate 30 is a substrate having a light transmitting property to light to be emitted from the cavity layer 32, and is, for example, an n-type GaAs substrate. For example, silicon (Si) or the like is included as an n-type impurity in the n-type GaAs substrate. The DBR layer 31 includes, for example, a low refractive index layer and a high refractive index layer that are alternately stacked. The low refractive index layer includes, for example, n-type Alₓ₅Ga₁₋ₓ₅As (0 < x5 < 1) having a thickness of λ₀(4n), where n is a refractive index of the low refractive index layer. The oscillation wavelength λ₀ is, for example, 940 nm that is a wavelength for optical communication. The high refractive index layer includes, for example, n-type Alₓ₆Ga₁₋ₓ₆As (0 ≤ x6 < x5) having a thickness of λ₀/(4n), where n is a refractive index of the high refractive index layer. The low refractive index layer includes a material having a higher Al (aluminum) composition ratio than that of the high refractive index layer. For example, silicon (Si) or the like is included as an n-type impurity in the DBR layer 31.

The cavity layer 32 is designed to suit the oscillation wavelength λ₀ and a use. The cavity layer 32 includes, for example, a stack in which the active layer 32A and a barrier layer are alternately stacked. The cavity layer 32 may further include, for example, a pair of guide layers sandwiching the above-described stack. In a case where a laser characteristic of the oscillation wavelength λ₀ of 940 nm is to be obtained, the above-described stack has, for example, a configuration in which the active layer 32A including In_{0.2}Ga_{0.8}As having a thickness of 8 nm and a barrier layer including GaAs having a thickness of 10 nm are alternately stacked, and the above-described guide layers each include, for example, Al_{0.4}Ga_{0.6}As having a thickness of 100 nm. The cavity layer 32 includes, for example, a non-doped semiconductor. Of the cavity layer 32, a region facing the current injection region 33A described later serves as a light emission region when a current is injected into the surface emitting laser 2.

The current confinement layer 33 includes an opening (the current injection region 33A) for confinement of a current to be injected into the cavity layer 32. The current injection region 33Ais, for example, circular. The current confinement layer 33 includes a current confinement region 33B around the current injection region 33A. The current confinement region 33B includes an insulating material, for example, Al₂Oₓ. The current confinement layer 33 is formed by, for example, partially oxidizing AlGaAs having a high Al composition, or AlAs. The current confinement layer 33 may be provided, for example, at a position of the low refractive index layer close to the cavity layer 32 within the DBR layer 34.

The DBR layer 34 includes, for example, a low refractive index layer and a high refractive index layer that are alternately stacked. The low refractive index layer includes, for example, p-type Alₓ₇Ga₁₋ₓ₇As (0 < x7 < 1) having a thickness of λ₀/(4n), where n is a refractive index of the low refractive index layer. The high refractive index layer includes, for example, p-type Alₓ₈Ga₁₋ₓ₈As (0 ≤ x8 < x7) having a thickness of λ₀/(4n), where n is a refractive index of the high refractive index layer. The low refractive index layer includes a material having a higher Al (aluminum) composition ratio than that of the high refractive index layer. For example, carbon (C), zinc (Zn), magnesium (Mg), beryllium (Be), etc. are included as p-type impurities in the DBR layer 34.

The number of pairs of the low refractive index layer and the high refractive index layer in the DBR layer 31 is, for example, less than the number of pairs of the low refractive index layer and the high refractive index layer in the DBR layer 34. The number of pairs in the DBR layer 14 is half or less the number of pairs necessary to serve as a DBR layer when the dielectric layer 38 and the reflection metal layer 39 are not provided. One reason for this is that the dielectric layer 38 and the reflection metal layer 39 assist a light reflection function of the DBR layer 31, and it is thus possible to reduce the number of pairs of the low refractive index layer and the high refractive index layer in the DBR layer 31 by ability of the dielectric layer 38 and the reflection metal layer 39 to reflect light.

The dielectric layer 38 includes, for example, Al₂O₃, SiO₂, SiNx, TiO₂, or Ta₂O₅ having a thickness of λ₀/(4n), where n is a refractive index of the dielectric layer 38. The reflection metal layer 39 includes, for example, gold (Au), silver (Ag), or aluminum (Al). The reflection metal layer 39 has a film thickness of, for example, 20 nm or more.

The electrode layer 36 is formed on a top surface of the DBR layer 34. The electrode layer 36 includes an opening at least at a portion opposed to the current injection region 33A, and is formed in contact with an outer edge of the top surface of the DBR layer 34. The electrode layer 36 has, for example, a structure in which titanium (Ti), platinum (Pt), and gold (Au) are stacked in order from the top surface of the DBR layer 34, and is electrically coupled to the DBR layer 34. Of the top surface of the DBR layer 34, a surface exposed inside the opening of the electrode layer 36 is the light output surface 2S from which light (laser light L) from the surface emitting laser 2 is to be outputted to outside.

The pad electrode 37 serves as an external terminal of the surface emitting laser 2. The pad electrode 37 is electrically coupled to the electrode layer 36. The pad electrode 37 includes, for example, titanium (Ti), platinum (Pt), and gold (Au) stacked in this order. The pad electrode 37 is, for example, formed integrally with the electrode layer 36. The pad electrode 37 is, for example, formed in contact with a top surface of the embedding layer 35.

The embedding layer 35 is a layer intended to provide a formation surface for the pad electrode 37. The embedding layer 35 is formed around the mesa section 40, and embeds a portion of the mesa section 40. It is preferable that the top surface of the embedding layer 35 and the top surface of the DBR layer 34 be nearly equal to each other in height. The embedding layer 35 includes a resin having an insulation property, for example, polyimide.

The electrode layer 41 serves as an external terminal of the surface emitting laser 2. The electrode layer 41 is electrically coupled to the substrate 30. The electrode layer 41 includes, for example, an alloy of gold (Au) and germanium (Ge), nickel (Ni), and gold (Au) stacked in this order from the substrate 10. The electrode layer 41 includes an opening at least at a portion opposed to the current injection region 33A, and is formed in contact with an outer edge of the opening 30A of the back surface of the substrate 30.

### [Method of Manufacturing]

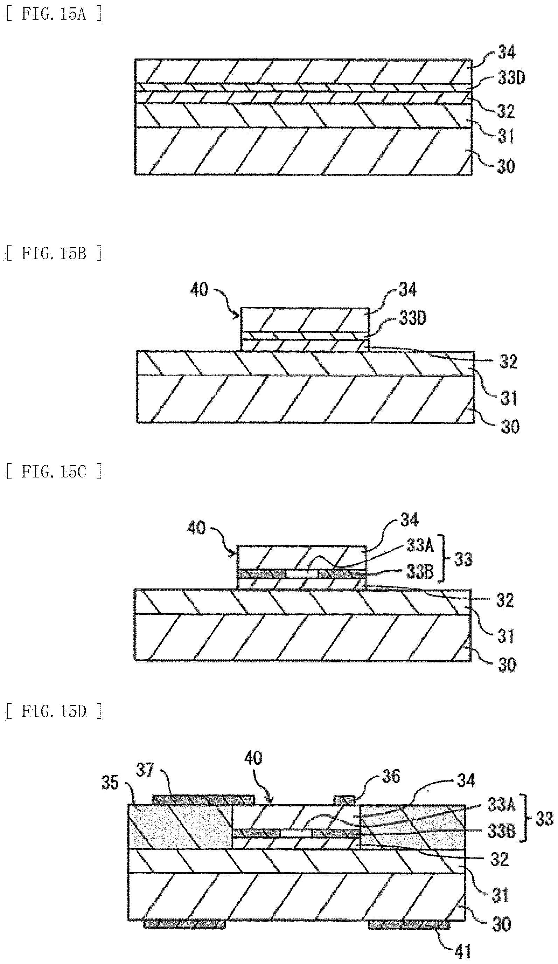

Next, a method of manufacturing the surface emitting laser 2 according to the present embodiment will be described. FIG. 15A to FIG. 15E illustrate an example of a procedure of manufacturing the surface emitting laser 2.

To manufacture the surface emitting laser 2, on the substrate 10 including, for example, GaAs, a compound semiconductor is collectively formed by, for example, an epitaxial crystal growth method such as the MOCVD method. At this time, for example, a methyl-based organic metal gas such as trimethylaluminum (TMAl), trimethylgallium (TMGa), or trimethylindium (TMIn), and an arsine (AsH₃) gas are used as raw materials of the compound semiconductor, disilane (Si₂H₆), for example, is used as a raw material of a donor impurity, and carbon tetrabromide (CBr₄), for example, is used as a raw material of an acceptor impurity.

First, on a surface of the substrate 30, the DBR layer 31, the cavity layer 32, an oxidation layer 33D, and the DBR layer 34 are formed in this order by, for example, an epitaxial crystal growth method such as the MOCVD method (FIG. 15A). Next, for example, a circular resist layer (not illustrated) is formed, and then among the DBR layer 34, the oxidation layer 33D, the cavity layer 32, and the DBR layer 31, at least the DBR layer 34, the oxidation layer 33D, and the cavity layer 32 are selectively etched using this resist layer as a mask. At this time, it is preferable to use, for example, RIE with a Cl-based gas. For example, as illustrated in FIG. 15B, the mesa section 40 shaped like a column is thereby formed to have a height reaching at least the DBR layer 34, the oxidation layer 33D, and the cavity layer 32, among the DBR layer 34, the oxidation layer 33D, the cavity layer 32, and the DBR layer 31. At this time, the oxidation layer 33D is exposed in the side face of the mesa section 40. Thereafter, the resist layer is removed.

Next, in a water-vapor atmosphere, oxidation treatment is performed at a high temperature to selectively oxidize Al included in the oxidation layer 33D from the side face of the mesa section 40. Alternatively, Al included in the oxidation layer 33D is selectively oxidized from the side face of the mesa section 40 by a wet oxidation method. This makes an outer edge region of the oxidation layer 33D into an insulating layer (aluminum oxide) in the mesa section 40, thereby forming the current confinement layer 33 (FIG. 15C). Subsequently, the embedding layer 35 including, for example, an insulating resin such as polyimide is formed around the mesa section 40, and then the electrode layer 36 and the pad electrode 37 are formed on the top surface of each of the DBR layer 34 and the embedding layer 35 (FIG. 15D).

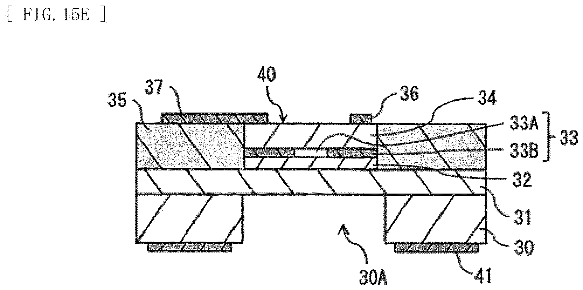

Next, the opening 30A is formed in the back surface of the substrate 30 (FIG. 15E). Then, for example, a dielectric layer is formed by sputtering, and an unnecessary portion of the dielectric layer thus formed is removed by a lift-off method. In this way, the dielectric layer 38 is formed on a top surface of the mesa section 40 (FIG. 12). Finally, a reflection metal layer is formed by a vapor deposition method, and an unnecessary portion of the reflection metal layer thus formed is removed by a lift-off method. The reflection metal layer 39 is thereby formed (FIG. 1). In this way, the surface emitting laser 2 is manufactured.

### [Operation]

In the surface emitting laser 2 having such a configuration, when a predetermined voltage is applied between the pad electrode 37 electrically coupled to the DBR layer 34 and the electrode layer 41 electrically coupled to the DBR layer 31, a current is injected into the cavity layer 32 through the current injection region 33A, thus causing light emission to occur as a result of recombination of electrons and holes. This results in laser oscillation at the oscillation wavelength λ₀ caused by the cavity layer 32, the pair of DBR layers 31 and 34, the dielectric layer 38, and the reflection metal layer 39. Subsequently, light leaking out of the DBR layer 34 becomes beam-shaped laser light and is outputted from the light output surface 2S to outside.

### [Effects]

Next, effects of the surface emitting laser 2 according to the present embodiment will be described.

In the present embodiment, the dielectric layer 38 and the reflection metal layer 39 assisting the function of the DBR layer 31 are provided at the terminal end of the reflecting mirror on the side of the DBR layer 31 when viewed from the cavity layer 32. Laser oscillation is thus caused to occur at the oscillation wavelength λ₀ by the cavity layer 32, the pair of DBR layers 31 and 34, the dielectric layer 38, and the reflection metal layer 39. At this time, even in a case where the number of pairs in the DBR layer 31 is less than the number of pairs in the DBR layer 34, it is possible to cause the laser oscillation at the oscillation wavelength λ₀, and besides, it is possible to maintain the light extraction efficiency at a high level, while suppressing a rise in the threshold gain of the laser oscillation. It is therefore possible to make the number of pairs in the DBR layer 31 less than the number of pairs in the DBR layer 34. As a result, it is possible to achieve enhancement of device properties and productivity improvement by a reduction in the number of pairs in the DBR layer 31. Further, the reduction in the number of pairs in the DBR layer 31 makes it easy to detect an F-P Dip wavelength, thereby making it possible to improve characteristic evaluation accuracy of an epi-wafer.

Further, in the present embodiment, the electrode layer 41 for injection of a current into the surface emitting laser 2 is provided on a path different from the optical path in the vertical cavity structure. Specifically, the electrode layer 41 is provided at a position where the current is directly injectable into the DBR layer 31 without interposition of the dielectric layer 38 and the reflection metal layer 39. For example, as illustrated in FIG. 12, the electrode layer 41 is formed in contact with the outer edge of the opening 30A of the back surface of the substrate 30, and is in contact with the back surface of the substrate 30 except a portion thereof opposed to the current injection region 33A. This makes it possible to reduce a drive voltage of the surface emitting laser 2. Further, because the electrode layer 41 is provided on the path different from the optical path in the vertical cavity structure, it is not necessary to use an electrically conductive material in forming the dielectric layer 38. It is thus possible to select, for the dielectric layer 38, a material and a manufacturing method that make it easy to control a film thickness.

Although the present disclosure has been described above with reference to the embodiments and the modification example thereof, the present disclosure is not limited thereto, and may be modified in a variety of ways. It is to be noted that the effects described in the present specification are mere examples. The effects of the present disclosure are not limited to the effects described in the present specification. The present disclosure may have effects other than the effects described in the present specification.

Further, the present disclosure may include the following configurations, for example.
(1) A surface emitting laser including:
   an active layer;
   a first DBR layer and a second DBR layer sandwiching the active layer; and
   a dielectric layer and a reflection metal layer corresponding to a terminal end of a reflecting mirror on a side of the second DBR layer when viewed from the active layer.
(2) The surface emitting laser according to (1), in which
   the dielectric layer is in contact with the second DBR layer at a side opposite to the active layer, and
   the reflection metal layer is in contact with the second DBR layer with the dielectric layer interposed therebetween.
(3) The surface emitting laser according to (1) or (2), in which the number of pairs in the second DBR layer is less than the number of pairs in the first DBR layer.
(4) The surface emitting laser according to any one of (1) to (3), further including an electrode layer on a path different from an optical path in a vertical cavity structure including the first DBR layer and the second DBR layer, the electrode layer being provided for injection of a current to the active layer.
(5) The surface emitting laser according to any one of (1) to (4), in which the dielectric layer includes Al₂O₃, SiO₂, SiNx, TiO₂, or Ta₂O₅ having a thickness of an oscillation wavelength/(4n), where n is a refractive index of the dielectric layer.
(6) The surface emitting laser according to any one of (1) to (5), in which the reflection metal layer includes gold, silver, or aluminum.
(7) A surface emitting laser including:
   an active layer;
   a first DBR layer and a second DBR layer sandwiching the active layer; and
   a transparent conductor layer and a reflection metal layer corresponding to a terminal end of a reflecting mirror on a side of the second DBR layer when viewed from the active layer.
(8) The surface emitting laser according to (7), further including an electrode layer on a path different from an optical path in a vertical cavity structure including the first DBR layer and the second DBR layer, the electrode layer feeding a current to be injected into the active layer.
(9) The surface emitting laser according to (7) or (8), in which the transparent conductor layer includes ITO or ITiO having a thickness of an oscillation wavelength/(4n), where n is a refractive index of the transparent conductor layer.

According to the surface emitting laser of an embodiment of the present disclosure, the dielectric layer and the reflection metal layer are provided at the terminal end of the reflecting mirror on the side of the second DBR layer when viewed from the active layer, and thus it is possible to reduce the number of pairs in the DBR. It is to be noted that the effects of the present disclosure are not limited to the effects described herein, and may be any of the effects described in the present specification.

This application claims priority from Japanese Patent Application No. 2018-041042 filed with the Japan Patent Office on March 7, 2018, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A surface emitting laser comprising:
an active layer;
a first DBR (distributed Bragg reflector) layer and a second DBR layer sandwiching the active layer; and
a dielectric layer and a reflection metal layer corresponding to a terminal end of a reflecting mirror on a side of the second DBR layer when viewed from the active layer.

2. The surface emitting laser according to claim 1, wherein
the dielectric layer is in contact with the second DBR layer at a side opposite to the active layer, and
the reflection metal layer is in contact with the second DBR layer with the dielectric layer interposed therebetween.

3. The surface emitting laser according to claim 1, wherein a number of pairs in the second DBR layer is less than a number of pairs in the first DBR layer.

4. The surface emitting laser according to claim 1, further comprising an electrode layer on a path different from an optical path in a vertical cavity structure including the first DBR layer and the second DBR layer, the electrode layer being provided for injection of a current to the active layer.

5. The surface emitting laser according to claim 1, wherein the dielectric layer includes Al₂O₃, SiO₂, SiNx, TiO₂, or Ta₂O₅ having a thickness of an oscillation wavelength/(4n), where n is a refractive index of the dielectric layer.

6. The surface emitting laser according to claim 1, wherein the reflection metal layer includes gold, silver, or aluminum.

7. A surface emitting laser comprising:
an active layer;
a first DBR (distributed Bragg reflector) layer and a second DBR layer sandwiching the active layer; and
a transparent conductor layer and a reflection metal layer corresponding to a terminal end of a reflecting mirror on a side of the second DBR layer when viewed from the active layer.

8. The surface emitting laser according to claim 7, further comprising an electrode layer on a path different from an optical path in a vertical cavity structure including the first DBR layer and the second DBR layer, the electrode layer feeding a current to be injected into the active layer.

9. The surface emitting laser according to claim 7, wherein the transparent conductor layer includes ITO (Indium Tin Oxide) or ITiO (Indium Titanium Oxide) having a thickness of an oscillation wavelength/(4n), where n is a refractive index of the transparent conductor layer.
